# EUROPEAN PATENT APPLICATION

(11) **EP 1 909 341 A1**
(43) Date of publication of application: **09.04.2008**
(21) Application number: 06781659.5
(22) Date of filing: 26.07.2006
(51) Int. Cl.: H01L 51/00

(54) **ORGANIC POWER GENERATING DEVICE**

(30) Priority: 26.07.2005 JP 2005216517
(71) Applicant: MATSUSHITA ELECTRIC WORKS, LTD., Kadoma-shi, Osaka-fu 571-8686 (JP)
(72) Inventor: KAWANO, Kenji c/o MATSUSHITA ELECTRIC WORKS, LTD., Kadoma-shi, Osaka 5718686 (JP); Ito, Norihiro c/o MATSUSHITA ELECTRIC WORKS, LTD., Kadoma-shi, Osaka 5718686 (JP); Komoda, Takuya c/o MATSUSHITA ELECTRIC WORKS, LTD., Kadoma-shi, Osaka 5718686 (JP); Sakai, Jun c/o MATSUSHITA ELECTRIC WORKS, LTD., Kadoma-shi, Osaka 5718686 (JP)
(74) Representative: Mackenzie, Andrew Bryan
(86) International application number: PCT/JP2006/314747
(87) International publication number: WO 2007/013496

(57) **Abstract**

In an organic power generating device that generates electricity by receiving light, a positive electrode (2) and a negative electrode (3), at least one of which has transparency, a power generating layer (1) which is formed of a mixture of an electron donor material and a hole donor material and generates electricity upon reception of light and disposed between the positive electrode and the negative electrode, and an inorganic layer (4) which has a work function larger than that of the positive electrode and is disposed between the power generating layer and the positive electrode, are provided. Accordingly, an efficiency to take off electric charges from the power generating layer can be increased, so that the organic power generating device with high efficiency and long life can be obtained.

## Description

### Technical Field

The present invention relates to an organic phtovoltaic device which is used in organic solar cells and comprises power generating layers to generate electric power upon reception of light.

### Background Art

It is required to develop an economical and high-performance clean energy so as not to impose any burden to global environment, and thus, solar cells utilizing solar light draw attention as sources of such clean energy.

Many of existing solar cells are inorganic solar cells using single-crystalline silicon, poly-crystalline silicon, or amorphous silicon. These inorganic silicon solar cells, however, are not popularized widely because of high-costs due to complication of manufacturing processes of them. In order to solve such a disadvantage, it is tried to develop organic solar cells using organic materials enabling low-costs and enlarging areas with simple processes.

Among the organic solar cells, it was announced by Professor Gratzel in Swiss Lausanne Collage of Engineering that a dye sensitizing type solar cell had a high conversion efficiency of 10% on the basis of photochemical reaction using porous titanium oxide, ruthenium pigment, iodine and iodine ion (B. O' Regan, M. Gratzel, Nature, 353, 737 (1991)).

In addition, it was announced that a low-molecular-weight type organic thin solar cell, which was formed by vacuum evaporation method with using an electric donor and an electric acceptor of low-molecular-weight, had a conversion efficiency of 3.6% (P. Peumans and S. R. Forrest, Appl. Phys. Lett. 79, 126 (2001)).

In such organic solar cells, there were various proposals with respect to materials and structures for electric power generating layers which generate electricity upon reception of light for improving conversion efficiency.

As disclosed in JP 2004-319131A, for example, it is known that a photoelectric transducer, which uses a water-soluble polymer formed of aqueous solution of strongly acidic such as poly(3,4-etylenedioxythiophene)poly(styrenesulfonate) (PEDOT:PSS) layer to extract electric charges from power generating layers, enables to improve the conversion efficiency. Such transducer, however, has a problem that characteristic features may be deteriorated significantly due to dispersion of impurities such as In (indium) by dissolution of transparent electrodes made of ITO (indium tin oxide) or IZO (indium zinc oxide) when forming an electric charge extraction layer. In addition, when atmospheric moisture is absorbed into the electric charge extraction layer, characteristics are remarkably deteriorated. In this way, the device shown in the Official Gazette is not considered to satisfy the efficiency and lifetime simultaneously, so that it needs improvement of the electric charge extraction layer.

### Disclosure of Invention

The present invention is conceived in view of the above mentioned problems, and intends to provide an organic power generating device which enables to realize a long life with high efficiency.

The present invention is an organic power generating device which generates electricity upon reception of light characterized by comprising: a positive electrode and a negative electrode, at least one of which has transparency; a power generating layer which is formed of a mixture of an electron donor material and a hole donor material and generates electricity upon reception of light and disposed between the positive electrode and the negative electrode; and an inorganic layer which has a work function larger than that of the positive electrode and is disposed between the power generating layer and the positive electrode. By such a configuration, electric charges can be extracted from the power generating layer effectively, so that an organic power generating device with high efficiency and long life can be obtained.

It is preferable that the layer of inorganic matter is formed to include an oxide of a transition metal selected among group 4, group 5, group 6 and group 7.

It is preferable that the layer of inorganic matter consists of only elements in group 14.

It is preferable that the organic power generating device is used in an organic solar cell or an organic photo-detector of a low light irradiation region equal to or smaller than 100 mW/cm² of light intensity.

### Brief Description of Drawings

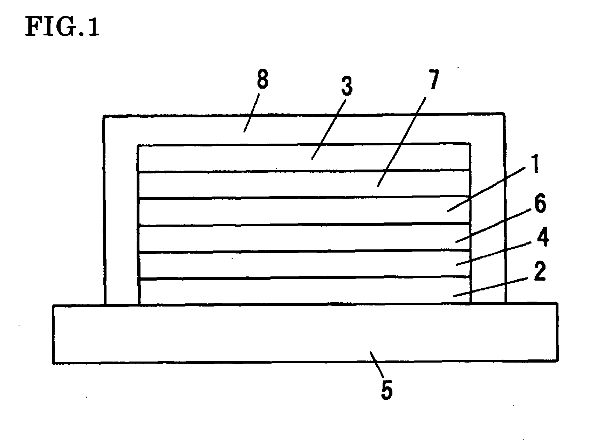

FIG. 1 is a structural diagram showing layers of a power generating device in accordance with an embodiment of the present invention.

### Best Mode for Carrying Out the Invention

An organic power generating device in accordance with an embodiment of the present invention is described referring to FIG.1. FIG. 1 shows a configuration of layers of the organic power generating device. The organic power generating device is established by providing a power generating layer 1 between a positive electrode 2 and a negative electrode 3 at least one of which has transparency, and providing an inorganic layer 4, which has a work function larger than that of the positive electrode 2, between the positive electrode 2 and the power generating layer 1.

In the organic power generating device, the positive electrode 2, the inorganic layer 4, a hole conveyance layer 6, the power generating layer 1, an electron conveyance layer 7 and the negative electrode 3 are piled up on a substrate 5 in this order, and uncovered surfaces of these layers 2, 3, 4, 6, and 7 are coated by a surface protection layer 8. When light enters into the power generating layer 1 from a side of the substrate 5, the substrate 5 and the positive electrode 2 are formed to have translucency by a transparent material, for example. When light enters into the power generating layer 1 from a side of the surface protection layer 8, the surface protection layer 8 and the negative electrode 3 are formed to have translucency by a transparent material, for example.

The configuration of layers of the organic power generating device is essentially in the order of the positive electrode 2, the inorganic layer 4, the power generating layer 1, and the negative electrode 3. It, however, is possible to configure the layers as shown in FIG. 1, because even when the hole conveyance layer 6 is provided for conveying holes selectively between the inorganic layer 4 and the power generating layer 1, it may not disturb expression of characteristics of the inorganic layer 4, and it increases effect of hole conveyance toward the positive electrode. In addition to this, it is preferable to structure the layers in an order of the positive electrode 2, the inorganic layer 4, the hole conveyance layer 6, the power generating layer 1 and the negative electrode 3, or in an order of the positive electrode 2, the inorganic layer 4, the power generating layer 1, the electron conveyance layer 7 and the negative electrode 3.

Materials that constitute the above mentioned organic power generating device is described below.

When the substrate 5 is provided on the side of light incident face of the organic power generating device, it is formed of a material having transparency, and it may be colored one on some level or it may be a frosted glass other than clear and colorless one. For example, a transparent glass plate such as a soda lime glass or non-alkali glass, or a plastic film or a plastic sheet which is formed by an arbitrary method from a resin such as polyester, polyolefin, polyamide or epoxy or a fluorinated resin can be used. In addition, it is possible to use a thing having light diffusion effect by including grains, powders, bubbles which have different refraction index from that of a base material of the substrate 5 into the substrate 5. When the substrate 5 is not provided on the side of light incident face, material of it is not limited in particular, if it can support the respective layers for power generation.

The positive electrode 2 is an electrode to collect holes generated in the power generating layer 1 effectively, and it is preferable to use a material for electrode such as a metal, an alloy, a chemical compound having electrical conductivity, or a mixture of them having a large work function. In particular, it is preferable to use a material for electrode having a work function equal to or larger than 4 eV. As for such material for electrode, metals such as gold, or transparent materials having electrical conductivity such as CuI, ITO, SnO₂, ZnO and IZO can be recited. The positive electrode 2 can be formed as a thin film by forming a film of such a material for electrode on the substrate 5 by a method such as vacuum deposition or sputtering, for example.

As for a material for conveying holes that constitute the hole conveyance layer 6, it is possible to recite chemical compounds having a performance for conveying holes, an effect for conveying holes from the power generating layer 1, a splendid effect for conveying holes toward the positive electrode 2, characteristics to block electrons and a splendid performance to be formed as a thin film. Specifically, polymeric materials having electrical conductivity such as phthalocyanine derivative, naphthalocyanine derivative, porphyrin derivative, aromatic series diamine chemical compound such as N,N'-bis(3-methylphenyl)-(1,1'-biphenyl)-4,4'-diamine (TPD), or 4,4'-bis[N-(naphthyl)-N-phenyl-Amino] biphenyl (α -NPD), oxazole, oxadiazole, triazole, imidazole, imidazolone, stilbene derivative, pyrazoline derivative, tetrahydroimidazole, polyarylalkane, butadiene, 4,4',4"-tris(N-(3-methylphenyl)N-phenyl Amino) triphenylamine (m-MTDATA) and polyvinylcarbazole, poly silane, aminopyridine derivative can be recited, but it is not limited to these.

The negative electrode 3 is an electrode to collect electrons generated in the power generating layer 1 effectively, so that it is preferable to use a material for electrode such as a metal, an alloy, a chemical compound having electrical conductivity, or a mixture of them having a small work function, and especially preferable to have a work function equal to or smaller than 5 eV. As for a material of the negative electrode 3, an alkali metal, a halogenide of alkali metal, an oxide of alkali metal, an alkaline earth metal, a rare earth, and an alloy of one of these and another metal, specifically, sodium, sodium-potassium alloy, lithium, magnesium, mixture of magnesium-silver, mixture of magnesium-indium, aluminum-lithium alloy, and mixture of Al/LiF can be recited, as example. Furthermore, aluminum, mixture of Al/Al₂O₃ can be used, too. Still furthermore, it is preferable to form the negative electrode 3 with using an oxide of alkali metal, a halogenide of alkali metal or a metal oxide is used as a groundwork, and laminating one or more layer of the above mentioned materials having a work function equal to or smaller than 5 eV (or alloy including the same). For example, lamination layers of an alkali metal and Al, lamination layers of a halogenide of alkali metal and alkaline earth metal and Al, lamination layers of Al₂O₃ and Al are given as examples. The negative electrode 3 can be manufactured by forming such materials for electrode into thin film by a method of vacuum deposition or sputtering.

As for a material for the electron conveyance layer 7, it is possible to recite chemical compounds having a performance for conveying electrons, a splendid effect for conveying electrons toward the negative electrode 3, characteristics to block holes and a splendid performance to be formed as a thin film. Specifically, Bathocuproine, Bathophenanthroline, derivative of those, TPBi, Silole chemical compound, triazole chemical compound, tris-(8-hydroxyquinolinqte) aluminum complex, bis-(4-methyl-8-qunolinate) aluminum complex, oxiadiazole chemical compound, distyrileallylene derivative, Silole chemical compound (SIC), TPBI(2,2',2"-(1,3,5-benzenetrill)-tris-[1-phenyl-1H benzimidazole]) are given, but it is not limited to these in particular, if it is a material of electron conveying property. In addition, it is preferable the material has electron transfer rate equal to re larger than 10⁻⁶ cm²/Vs, and more preferably, 10⁻⁵ cm²/Vs.

In addition, it is possible to provide an electron injection layer through which electrons are effectively injected between the negative electrode 3 and the electron conveyance layer 7. As for a material used for such an electron injection layer, mixture of a material used for the negative electrode 3 and a material used for the electron conveyance layer 7 is given.

The surface protection layer 8 can be formed as a thin film by laminating metal such as Al by sputtering; deposition, sputtering, CVD, plasma polymerization, spreading and ultraviolet curing or hot curing of fluorine system chemical compound, fluorine system macromolecule; or other organic numerator or macromolecule, or other methods. Alternatively, a structure of film shape, sheet shape or plate shape having transparency and gas barrier property can be provided.
When the surface protection layer 8 is provided in the side of light incident face of the organic power generating device, it is preferable that the surface protection layer 8 has a photo transmittance equal to or larger than 70% so as to reach the light to the organic power generating layer 1.

The power generating layer 1 is formed by mixture of an electron donor material (semiconductor with electron donation characteristic) and a hole donor material (semiconductor having hole donation characteristic).

As for such electron donor material, phthalocyanine system pigment, indigo, tioindigo system pigment, quinacridone system pigment, merocyanine chemical compound, cyanine chemical compound, squalium chemical compound, polycyclic aromatic compounds, charge transfer agent used in an organic electrophotography photoreceptor, electroconductive organic charge transfer complex, or electroconductive macromolecule that donates electrons can be used.

As for phthalocyanine system pigment, divalent one having a central metal such as Cu, Zn, Co, Ni, Pb, Pt, Fe, Mg, metal-free phthalocyanine, aluminium chlorophthalocyanine, indium chlorophthalocyanine, phthalocyanine of the trivalent metal such as gallium chlorophthalocyanine in which halogen atom is coordinated, or phthalocyanine such as vanadylephthalocyanine or titanilephthalocyanine in which oxygen is coordinated is given, but it is not limited to those in particular.

As for polycyclic aromatic compounds, anthracene, tetracene, pentacene, or derivatives of those is given, but it is not limited to those in particular.

As for the charge transfer agent, hydrazone chemical compound, pyrazoline chemical compound, triphenylmethane chemical compound, or triphenylamine chemical compound is given, but it is not limited to these in particular.

As for the electroconductive organic charge transfer complex, tetrathiofulvalene, or tetraphenyltetrathiofulvalene is given, but it is not limited to this in particular.

As for the electroconductive macromolecule for donating electrons, poly(3-alkylthiophene), polyparaphenylenevinylene derivative, polyfluorene derivative, or oligomer of electroconductivity macromolecule, which is soluble in organic solvent such as toluene, is given, but it is not limited to these in particular.

In addition, as for the hole donor material, compound semiconductor corpuscle is given, and compound semiconductor nanocrystal is desirably used, in particular. Hereupon, nanocrystal has a size of 1 to 100 nm. In addition, rod shape, sphericak shape and tetrapod shape are included in nanocrystalline configuration. As for the specific material, group III-V compound semiconductor crystal such as InP, InAs, GaP, GaAs, group II-VI compound semiconductor crystal such as CdSe, CdS, CdTe, ZnS, oxide semiconductor crystal such as ZnO, SiO₂, TiO₂, Al₂O₃, or CuInSe₂, CuInS is given, but it is not limited to these in particular. In addition, low numerator material or electroconductive macromolecule that is it formed of fullerene derivatives can be used, if it can transport electrons.

In the present invention, the inorganic layer 4 that has a work function larger than that of the positive electrode 2 is provided between the positive electrode 2 and the power generating layer 1. In this way, by providing the inorganic layer 4 having a work function larger than that of the positive electrode 2 between the positive electrode 2 and the power generating layer 1, it is possible to increase efficiency to take out electric charges from the power generating layer 1, and thus, the organic power generating device having high conversion efficiency (power conversion efficiency) can be obtained. Hereupon, although it is not limited in particular, the work function of the inorganic layer 4 is preferably larger by a value in a range from 0.1 eV to 1.0 eV than that of the positive electrode 2.

As for the material forming this inorganic layer 4, an oxide of transition metal chosen among group 4, group 5, group 6, and group 7 can be given. Each has a large work function, few defection, strong anchoring power with the positive electrode 2, and stability for water or oxygen, so that the power generating efficiency and life property are improved. Specifically, molybdenum oxide, vanadium oxide, ruthenium oxide, tungsten oxide, or rhenium oxide can be given as preferable example. In addition, although the work function of ITO, which is generally used in forming of the transparent positive electrode 2, is in a range from 4.5 to 5.1 eV, that of molybdenum oxide is in a range from 5.2 to 5.6 eV, that of vanadium oxide is in a range from 5.3 to 5.7 eV, that of ruthenium oxide is in a range from 5.3 to 5.7 eV, that of tungsten oxide is in a range from 5.3 to 5.7 eV, and that of rhenium oxide is in a range from 5.3 to 5.7 eV.

The material of the inorganic layer 4 is not limited to the above mentioned one, if it has a work function larger than that of the positive electrode 2 and includes oxide of transition metal in group 4, group 5, group 6, or group 7. In addition, as for the method to form the inorganic layer 4, resistance heating vacuum deposition, electron-beam evaporation technique or sputtering technique is recited, but it is not limited to these, if it is possible to form the layer evenly with using the above mentioned material.

In addition, the inorganic layer 4 can be formed as a layer consists of only element of group 14. As for the element of group 14, carbon (C) or the like can be used. Since the element of group 14 has a large work function, few defection, strong anchoring power with the positive electrode 2, and stability for water or oxygen, the power generating efficiency and life property are improved. In addition, the work function of carbon (C) is in a range from 5.2 to 5.4 eV.

In the organic power generating device in accordance with the present invention that is configured by the above mentioned layer structure, the inorganic layer 4 can be formed uniform with few impurity in comparison with organic matter of poly(3,4-etylenedioxythiophene)poly(styrenesulfonate) (PEDOT:PSS) which was conventionally used, so that the efficiency to take out electric charges becomes higher in an area of low irradiation of light equal to or smaller than 100 mW/cm² of intensity of irradiation light, and it shows high efficiency characteristics. Therefore, the organic power generating device in accordance with the present invention can be used as an organic solar cell that converts solar light to electricity, and an organic photo-detector or an organic sensor that detects incident light and converts electricity, which are used in such an area of low irradiation of light. The present invention can be applied to entire of elements that generates electricity by receiving light, so that it is not limited to those.

### Working Example

Subsequently, the present invention is concretely described with reference to working examples.

### (Working Example 1)

A glass substrate 5 with ITO film (work function 4.8 eV) for forming the positive electrode 2, which was a product by KURAMOTO CO., LTD, was used. After performing ultrasonic washing with acetone and isopropyl alcohol (both of them were made by Kanto Chemical Co., Ltd.), Semico clean (which was a product of Furuuchi Chemical Corporation) and extra pure water for each 10 minutes, it was further washed with moisture of isopropyl alcohol and dried. Subsequently, surface treatment of the substrate 5 with ITO film was performed for three minutes with using an atmospheric pressure plasma surface treatment equipment (which was a product of Matsushita Electric Works, Ltd.,).

Subsequently, the substrate 5 with ITO film was set on a vacuum evaporation system (which was a product of Ulvac, Inc.), and the inorganic layer 4 was formed on the positive electrode 2 of ITO by vacuum evaporating molybdenum trioxide (MoO₃ which was a product of Kojundo Chemical Lab. Co., Ltd, work function 5.2 eV).

Subsequently, the organic power generating layer 1 with a thickness of 80 nm was formed on the inorganic layer 4 by spin coating of chlorobenzene solution into which poly(2-methoxy-5-(3,7-dimethyloctyloxty)-1,4-phenylenevin ylene ("MDMO-PPV" which was a product of American Dye Source Inc.) and [6,6]-phenyl C61-butylic acid methyl ester ("PCBM" which was a product of NanoC) which was a fullerene derivative were mixed at mass ratio 1:4.

Subsequently, the substrate 5 was set on the vacuum evaporation system (which was a product of Ulvac, Inc.) again, and the negative electrode 3 was formed on the organic power generating layer 1 by vacuum deposition of Al thin film with a thickness of 150 nm.

Subsequently, the substrate 5 on which respective layers were formed was transported into a globe box of dry nitrogen ambient atmosphere having dew point equal to or smaller than -76 degrees Celsius without exposure to air.
On the other hand, a powder of barium oxide was put into a bag having ventilation characteristic as absorbent of water, and it was attached on a glass sealing sheet with adhesive. In addition, a seal agent of an ultraviolet curing resin was previously applied to circumference of the sealing sheet, and then, the sealing sheet was attached with a sealing agent to the substrate 5 on which respective layers were formed in the globe box. By curing the sealing agent by UV, the organic power generating device providing the sealing sheet as the surface protection layer 8 was obtained.

### (Working Example 2)

Similar to the above mentioned working example 1, the glass substrate 5 with ITO film which was washed and surface treated was used. The inorganic layer 4 with a thickness 15 nm was formed on the positive electrode 2 of ITO by vacuum deposition of divanadiumpentoxide (V₂O₅, work function 5.4eV). The other processes were performed the same as those in the working example 1, so that the organic power generating device was obtained.

### (Working Example 3)

Similar to the above mentioned working example 1, the glass substrate 5 with ITO film which was washed and surface treated was used. The inorganic layer 4 consisting of amorphous carbon film (a-C, work function 5.2 eV) with a thickness 10 nm was formed on the positive electrode 2 of ITO by sputtering with a sputtering system (which was a product of ANELVA Technix Corporation) with using a target of carbon (which was a product of Kojundo Chemical Lab. Co., Ltd,). The other processes were performed the same as those in the working example 1, so that the organic power generating device was obtained.

### (Comparative Example 1)

An organic power generating device other than providing no layer between the positive electrode 2 and the power generating layer 1 was obtained similar to the working example 1.

### (Comparative Example 2)

An organic power generating device other than forming a layer of organic matter of poly(3,4-etylenedioxythiophene)poly(styrenesulfonate) (PEDOT:PSS) (which was a product of H.C.Starck LTD.) with a thickness 50 nm was formed between the positive electrode 2 and the power generating layer 1 instead of the inorganic layer 4 was obtained similar to the working example 1.

### (Comparative Example 3)

An organic power generating device other than forming a layer of silver (Ag: working function 4.5 eV) with a thickness 5 nm was formed between the positive electrode 2 and the power generating layer 1 instead of the inorganic layer 4 was obtained similar to the working example 1.

With respect to the organic power generating devices obtained in the working examples 1 to 2 and the comparative examples 1 to 3 as mentioned above, conversion efficiencies of them when irradiating quasi-solar light (AM1.5, 100 mW/cm²) by a solar simulator (which was a product of Yamashita Denso Corporation) were obtained. Results are shown in table 1.

**[Table 1]**

| | Material | Conversion Efficiency (%) |
|---|---|---|
| Working Example 1 | MoO₃ | 2.2 |
| Working Example 2 | V₂O₅ | 2.4 |
| Comparative Example 1 | Nothing | 1.2 |
| Comparative | PEDOT:PSS | 2.0 |
| Comparative Example 3 | Ag | 0.4 |

In addition, a maintenance factor (it is standardized with initial value) after three hours of conversion efficiency when the organic power generating devices obtained in the working examples 1 to 3 and the comparative example 2 as mentioned above were put in a dark place in the atmosphere. Results are shown in table 2.

**[Table 2]**

| | Material | Maintenance Factor (%) |
|---|---|---|
| Working Example 1 | MoO₃ | 89 |
| Working Example 2 | V₂O₅ | 84 |
| Working Example 3 | a-C | 80 |
| Comparative Example 2 | PEDOT:PSS | 52 |

Furthermore, conversion efficiencies of the organic power generating devices obtained in the working examples 1 to 2 and the comparative example 2 as mentioned above when irradiating quasi-solar light (AM1.5, 1 mW/cm² and 10 mW/cm²) of low light irradiation were obtained. Results are shown in table 3.

**[Table 3]**

| | Material | Conversion Efficiency in 1 m W/cm² | Conversion Efficiency in 10 m W/cm² |
|---|---|---|---|
| Working Example 1 | MoO₃ | 3.2 | 3.2 |
| Working Example 2 | V₂O₅ | 3.8 | 3.6 |
| Comparative Example 2 | PEDOT:PSS | 2.6 | 2.8 |

According to the results shown in tables 1 to 3, it could be confirmed that an organic power generating device with high conversion efficiency (including cases of low light irradiation equal to or smaller than 100 mW/cm²) and long life is manufactured by providing an inorganic layer 4 having a larger work function than that of a positive electrode 2 between the positive electrode 2 and a power generating layer 1 generating electricity by receiving light.
In addition, the present invention is not limited to the above mentioned configurations of the embodiments or working examples, and thus, it is possible to modify in various manner.
This application is based on Japanese patent application 2005-216517 filed in Japan, the contents of which are hereby incorporated by references.

## Claims

1. An organic power generating device which generates electricity upon reception of light **characterized by** comprising:
a positive electrode and a negative electrode, at least one of which has transparency;
a power generating layer which is formed of a mixture of an electron donor material and a hole donor material and generates electricity upon reception of light and disposed between the positive electrode and the negative electrode; and
an inorganic layer which has a work function larger than that of the positive electrode and is disposed between the power generating layer and the positive electrode.

2. The organic power generating device in accordance with claim 1, wherein the layer of inorganic matter is formed to include an oxide of a transition metal selected among group 4, group 5, group 6 and group 7.

3. The organic power generating device in accordance with claim 1, wherein the layer of inorganic matter consists of only elements in group 14.

4. The organic power generating device in accordance with one of claims 1 to 3, wherein it is used in an organic solar cell or an organic photo-detector of a low light irradiation region equal to or smaller than 100 mW/cm² of light intensity.
